(19) **Europäisches Patentamt / European Patent Office / Office européen des brevets**

(11) **EP 2 201 593 B1**

(12) **FASCICULE DE BREVET EUROPEEN**

(45) Date de publication et mention de la délivrance du brevet:
**01.02.2017 Bulletin 2017/05**

(21) Numéro de dépôt: **08842172.2**

(22) Date de dépôt: **09.10.2008**

(51) Int Cl.:
*H01J 37/32* (2006.01)    *H05H 1/46* (2006.01)

(86) Numéro de dépôt international:
**PCT/FR2008/051824**

(87) Numéro de publication internationale:
**WO 2009/053614 (30.04.2009 Gazette 2009/18)**

(54) **PROCEDE DE TRAITEMENT DE SURFACE D'AU MOINS UNE PIECE AU MOYEN DE SOURCES ELEMENTAIRES DE PLASMA PAR RESONANCE CYCLOTRONIQUE ELECTRONIQUE**

VERFAHREN ZUR BEHANDLUNG DER OBERFLÄCHE MINDESTENS EINES TEILS MITTELS EINZELNER QUELLEN EINES ELEKTRONEN-ZYKLOTRON-RESONANZ-PLASMAS

METHOD OF TREATING A SURFACE OF AT LEAST ONE PART BY MEANS OF INDIVIDUAL SOURCES OF AN ELECTRON CYCLOTRON RESONANCE PLASMA

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **16.10.2007 FR 0758368**

(43) Date de publication de la demande:
**30.06.2010 Bulletin 2010/26**

(73) Titulaire: **H.E.F.**
**42160 Andrezieux-Boutheon (FR)**

(72) Inventeurs:
• **SCHMIDT, Beat**
  **F-42210 Montrond Les Bains (FR)**

• **HEAU, Christophe**
  **F-42100 Saint Etienne (FR)**
• **MAURIN-PERRIER, Philippe**
  **F-42680 Saint Marcellin En Forez (FR)**

(74) Mandataire: **Cabinet Laurent & Charras**
**3 place de l'Hotel de Ville**
**CS 70203**
**42005 Saint-Etienne Cedex 1 (FR)**

(56) Documents cités:
| | |
|---|---|
| WO-A-2007/023350 | FR-A- 2 797 372 |
| FR-A- 2 895 208 | US-A- 4 948 750 |
| US-A- 5 378 284 | US-A- 6 010 755 |
| US-A1- 2005 001 554 | |

## Description

L'invention se rattache au secteur technique de la production de plasma par résonance cyclotronique électronique (RCE) à partir d'un milieu gazeux et concerne plus particulièrement un traitement de surface.

D'une manière parfaitement connue pour un homme du métier, le plasma généré par résonance cyclotronique électronique peut intervenir dans le traitement de surface de pièces métalliques ou non, tel que le nettoyage des pièces par décapage ionique, assistance ionique à un procédé de dépôt PVD, l'activation d'espèces gazeuses pour faire des revêtements PACVD... Ces méthodes de traitement de surface par plasma peuvent être utilisées, entre autres, dans le domaine de la mécanique, de l'optique, de la protection corrosion ou le traitement de surface pour la production d'énergie.

L'invention trouve une application particulièrement avantageuse dans le traitement d'une ou plusieurs pièces présentant de multiples faces à traiter, ou encore de formes dites complexes.

D'une manière connue, pour réaliser un traitement plasma sur des pièces de formes complexes, on réalise une polarisation desdites pièces qui peut s'effectuer en continu, en pulsé ou en radiofréquence, afin de créer un plasma directement à la surface des pièces à traiter. Cette solution présente l'inconvénient que la production de plasma et le bombardement de la surface par les ions du plasma, ne sont pas indépendants étant donné que la tension de travail détermine à la fois la densité de plasma et l'énergie des ions qui arrivent à la surface. On observe également que cette polarisation est efficace, uniquement à des pressions d'environ 1 à 10 Pa. Or, une telle pression, qui est relativement élevée pour un traitement de plasma, correspond à un libre parcours moyen faible, ce qui rend le transport de matière de ou vers les pièces à traiter, particulièrement difficile et favorise la formation de cathodes creuses entre les pièces, de sorte que le traitement obtenu n'est pas homogène. Pour éviter la formation de cathodes creuses, il est nécessaire d'être particulièrement attentif aux distances entre les pièces à traiter.

Même lorsque la pression de travail est abaissée en utilisant une source extérieure pour la création du plasma, par exemple des ondes radiofréquences ou des micro-ondes, demeure le problème du traitement homogène des pièces.

De nombreuses solutions techniques ont été proposées pour créer un plasma homogène à la surface de la ou des pièces à traiter.

Selon l'enseignement du brevet FR 2.658.025, le plasma homogène est obtenu en appliquant un champ magnétique homogène en volume. Le traitement homogène de la pièce résulte donc de l'homogénéité du plasma. En outre, ce type de configuration est extrêmement limitatif étant donné que les pièces de type ferromagnétique modifient nécessairement l'homogénéité du champ magnétique et par conséquent l'homogénéité du traitement.

Le brevet FR 2.838.020 propose une distribution de sources sur la périphérie d'un réacteur pour produire un confinement du plasma afin qu'il soit homogène en volume pour obtenir un traitement homogène. Selon cette solution, la nature magnétique ou non des pièces n'est pas importante mais l'homogénéité du plasma est nécessairement affectée par la présence des pièces. En effet, l'obtention d'un plasma homogène en volume, résulte de la somme des contributions des sources élémentaires distribuées sur la paroi du système de traitement. Le fait de placer un objet dans le plasma induit nécessairement un ombrage des sources nuisant à l'homogénéité du plasma et du traitement.

Une solution pour le traitement d'objets de géométrie plane ou ayant une géométrie de type surface légèrement courbée, ressort de l'enseignement du brevet FR 2.797.372. Selon l'enseignement de ce brevet, les sources de plasma sont positionnées à une distance constante de la surface des pièces à traiter, afin que le plasma soit homogène sur cette surface. Toutefois, comme indiqué, cette solution est spécifique à la géométrie déterminée de pièces. Pour chaque nouvelle géométrie, il est nécessaire de modifier le réacteur et plus particulièrement la position des sources de plasma.

Une autre solution, pour le traitement d'objets de géométrie plane, ressort de l'enseignement du brevet WO2007/023350. Ce brevet utilise une condition de résonance inhabituelle à l'induction magnétique B = $\pi$ mf/e où f est la fréquence de l'onde électromagnétique et m et e sont la masse et la charge de l'électron. Selon l'enseignement de ce brevet, une zone homogène de traitement est obtenue en rapprochant suffisamment les sources élémentaires afin d'obtenir une isosurface de l'induction B commune qui remplit la condition de résonance ci-dessus. A la fréquence habituellement utilisé de 2,45 GHz, cette condition est remplie pour un champ d'environ 437 Gauss. Cette solution nécessite alors de respecter des distances assez faibles entre les sources élémentaires inférieure à 5 cm quelle que soit la pression. Il est donc nécessaire de disposer de beaucoup de sources individuelles, ce qui augmente le coût du traitement. De même, le champ magnétique devant les sources, se trouve renforcé, ce qui peut être préjudiciable si l'on souhaite traiter des pièces magnétiques.

Une autre solution ressort de l'enseignement du brevet FR 2.826.506 qui concerne un dispositif d'amplification de courant d'une décharge électrique anormale. Le dispositif amplifie un plasma existant et nécessite donc, pour fonctionner, une association avec une autre électrode telle qu'une cathode magnétron. Le plasma est amplifié par l'application d'une tension positive. Or, un plasma très positif, présente comme inconvénient potentiel, la pulvérisation des parois du réacteur et par conséquent la contamination des pièces à traiter.

Le brevet US 5,378,284 décrit un procédé selon le préambule de la revendication 1.

L'invention s'est fixée pour but de remédier à ces inconvénients d'une manière simple, sûre, efficace et rationnelle.

Le problème que se propose de résoudre l'invention est de pouvoir réaliser un traitement de surface permettant de traiter des pièces de formes complexes de façon homogène, autrement dit de permettre un traitement homogène en volume bien que le plasma lui-même ne soit pas homogène dans le volume, ce qui limite le nombre de sources individuelles et diminue le coût du traitement.

Pour résoudre un tel problème, il a été conçu et mis au point un procédé et un dispositif de traitement de surface d'au moins une pièce au moyen de sources élémentaires de plasma par résonance cyclotronique électronique.

Le procédé consiste à soumettre la ou les pièces à au moins un mouvement par rapport à au moins une rangée linéaire fixe de sources élémentaires.

Le dispositif comprend au moins une rangée linéaire fixe de sources élémentaires disposées en regard de la ou des pièces assujetties à des moyens pour être soumise à au moins un mouvement de révolution.

Afin que les plasmas des sources élémentaires se superposent et donnent lieu à un traitement homogène le long de la rangée de sources élémentaires, la ou les rangées linéaires de sources élémentaires est(sont) disposée(s) d'une manière parallèle à l'axe de révolution de la ou des pièce(s).

Dans le cas de l'utilisation de plusieurs rangées linéaires, ces rangées sont disposées de manière à ce qu'elles n'interfèrent pas magnétiquement les unes avec les autres.

Selon ces caractéristiques, les sources élémentaires de plasma constituent une zone localisée de traitement, de sorte que l'extension d'échelle devient extrêmement simple.

Avantageusement, le mouvement de révolution est sous forme d'une rotation simple ou sous forme d'un mouvement planétaire, simple ou double.

Pour réaliser la condition de résonance cyclotronique électronique, les sources élémentaires peuvent être constituées d'un guide d'ondes coaxial et d'un embout contenant un aimant déterminé pour permettre la résonance cyclotronique électronique et adaptée à la fréquence du ou des générateurs d'alimentation desdites sources, comme décrit dans le brevet FR 2.797.372.

Pour préserver la symétrie de révolution du guide et pour garantir que les trajectoires des électrons se referment sur elles-mêmes, l'axe d'alimentation de l'aimant est colinéaire avec l'axe du guide d'ondes.

Selon une autre caractéristique, les sources élémentaires peuvent être alimentées par un générateur unique dont la puissance est divisée en parts égales entre les sources comme il ressort du brevet FR 2.798.552. Les sources élémentaires peuvent être alimentées par des générateurs dont la puissance est ajustée pour avoir un traitement homogène le long de la rangée desdites sources.

La distance minimale séparant deux sources est imposée par leur interaction magnétique. Elle est de l'ordre de deux fois le diamètre de l'aimant d'une source élémentaire. En deçà, l'interaction entre aimants, déplace la zone de RCE. Dans le cas de polarités opposées entre les deux aimants, la zone se rapproche trop de la surface de la source ; dans l'autre cas, elle s'en éloigne trop.

De la surface de la source, le plasma s'étale sur une distance $Rmax_o$ d'environ 5 cm à une pression $P_o$ de $2.10^{-3}$ mbar.

L'espacement maximum Dmax entre deux sources est donc limité à deux fois cette distance (environ 10cm). A pression plus faible, l'espacement maximum pourra être plus grand et, à pression plus haute, il sera plus faible. Cette distance est donc inversement proportionnelle à la pression.

$$Dmax = 2\, Rmax_o\, \frac{P_o}{P}$$

L'invention est exposée ci-après plus en détail à l'aide des figures des dessins annexés dans lesquels :

- la figure 1 est une vue de face à caractère purement schématique d'une forme de réalisation simplifiée du dispositif de traitement utilisé dans le procédé selon l'invention ;
- la figure 2 est une vue de dessus correspondant à la figure 1 dans le cas où le mouvement est du type révolution, sous forme d'une rotation simple ;
- la figure 3 est une vue semblable à la figure 2 dans le cas où le mouvement est du type révolution, sous forme d'un mouvement planétaire simple ;
- la figure 4 est une vue semblable à la figure 3 dans le cas d'un mouvement du type révolution sous forme d'un mouvement planétaire double ;
- les figures 5 et 6 montrent deux dispositions des sources élémentaires présentant une alimentation de polarités différentes (figure 5) ou, de manière préférée, de mêmes polarités (figure 6) ;
- la figure 7 est une vue en perspective d'un exemple de réalisation d'une source élémentaire ;

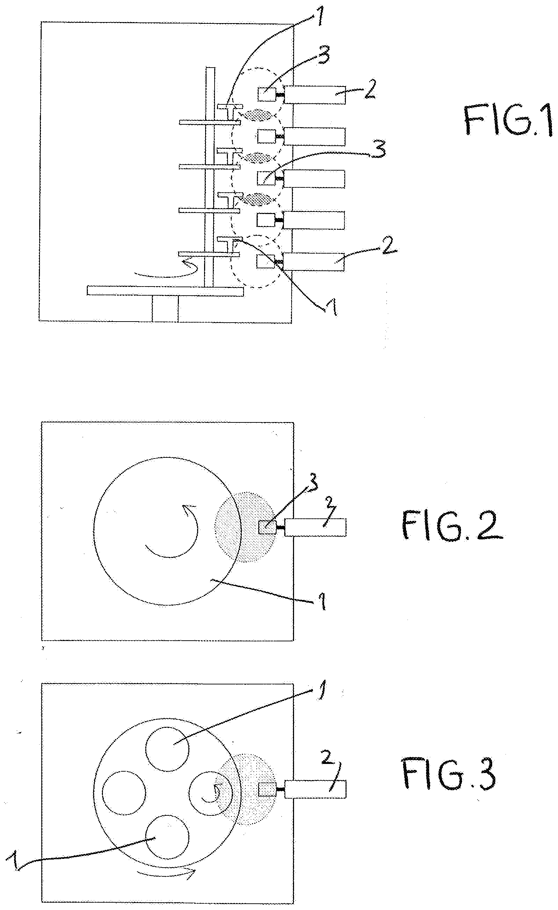

La figure 1 présente la structure générale du dispositif de traitement de la surface d'au moins une pièce (1) au moyen de sources élémentaires de plasma (2) par résonance cyclotronique électronique.

Selon l'invention, le dispositif comprend au moins une rangée linéaire fixe de sources élémentaires (2) disposées en regard de la ou des pièces (1).

D'une manière importante, la ou les pièces (1) est ou sont assujettie(s) à tout type de moyen connu et approprié pour être soumise(s) à au moins un mouvement de révolution.

Cette combinaison d'un mouvement de révolution des pièces avec les dispositions linéaires des sources élémentaires de plasma par résonance cyclotronique électronique, permet de produire un traitement homogène des surfaces tridimensionnelles des pièces complexes.

Le mouvement est adapté à la taille et à la géométrie des pièces à traiter et au chargement de l'enceinte sous vide. Pour une pièce de grande taille (figure 2), ce mouvement peut être constitué par une rotation simple.

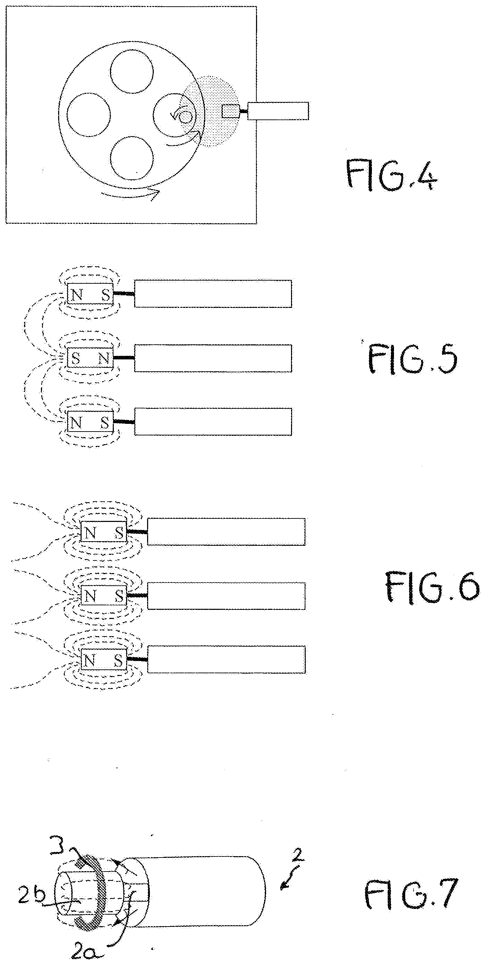

Pour des pièces de plus petite taille le mouvement peut être du type planétaire simple (figure 3) ou du type planétaire double (figure 4).

Dans une forme de réalisation, chaque source élémentaire (2) est constituée d'un guide d'ondes coaxial (2a) et d'un embout (2b) contenant un aimant suffisamment puissant (3) pour réaliser la résonance cyclotronique électronique. L'axe d'aimantation de l'aimant est colinéaire avec l'axe du guide coaxial (2a). Ces dispositions permettent de préserver la symétrie de révolution du guide et de garantir que les trajectoires des électrons se referment sur elles-mêmes.

L'aimantation des différentes sources (2) peut être librement déterminée, de sorte que des sources adjacentes peuvent avoir la même polarité (figure 6) ou des polarités différentes (figure 5).

Dans le cas où les polarités de deux aimants voisins sont opposées, des lignes de champ passent du pôle d'un aimant vers le pôle opposé de l'autre aimant. Des électrons chauds vont alors être piégés sur ses lignes et faire des aller-retours entre les deux aimants. Cette localisation d'électrons se trouve dans l'espace devant et entre deux sources et donne lieu à un plasma plus fort à cet endroit. Il en résulte une vitesse de dépôt plus importante entre deux aimants. Dans le cas où la polarisation des sources est la même, les lignes de champ de deux aimants voisins se repoussent et aucune ligne ne relie les deux aimants. La localisation d'électrons chauds dans l'espace devant et entre les sources n'a alors pas lieu et le dépôt est plus homogène. Pour retrouver une homogénéité équivalente avec les polarisations alternées, on peut augmenter la distance sources - substrat de quelques centimètres, mais dans ce cas on perd en vitesse de dépôt. Pour ces raisons la disposition préférentielle des aimants est celle où la polarité est partout la même.

Exemple 1 non-conforme : Dépôt en statique de carbone par PACVD

Deux configurations des polarités des aimants ont été utilisées : 6 embouts de même polarité et 6 embouts de polarité alternée. Les substrats sont placés face aux sources et restent fixe pendant le traitement.

Les mesures d'épaisseur montrent que le dépôt en statique n'est pas homogène. La configuration en polarités alternées donne un résultat un peu meilleur mais présente quand même des variations d'épaisseur de 30 à 40 %

Aimants de même polarité

Aimants de polarité alternée

»

Exemple 2 conforme : Dépôt de carbone par PACVD

Ce dépôt se fait à partir d'un hydrocarbure comme gaz précurseur. Deux configurations des polarités des aimants ont été utilisées: 6 embouts de même polarité et 6 embouts de polarité alternée.

Les mesures d'épaisseur du dépôt montrent deux choses:

- la vitesse moyenne de dépôt est plus élevée dans la configuration mettant en oeuvre des aimants de polarité alternée.
- L'uniformité de dépôt est meilleure dans la configuration mettant en oeuvre des aimants de même polarité.

## Aimants de polarité alternée

## Aimants de même polarité

Ces exemples montrent que l'association d'une rangée de sources avec un mouvement autour d'un axe parallèle à la rangée des sources donne un traitement homogène même si un traitement en statique donne un traitement très inhomogène.

Les sources élémentaires (2) sont alimentées par un générateur unique dont la puissance est divisée en parts égales entre les sources. Ou bien les sources élémentaires (2) sont alimentées par des générateurs dont la puissance est ajustée pour augmenter le degré d'homogénéité du traitement. Le ou les générateurs sont, par exemple, du type micro-ondes typiquement de 2,45 gigahertz.

Selon l'invention, comme le montre la figure 1, plusieurs sources (2) sont disposées le long d'une ligne parallèle à l'axe (X-X') de rotation des pièces. Il en résulte que les zones de plasma des sources élémentaires (2) se superposent permettant d'obtenir un traitement homogène le long de la rangée de sources élémentaires.

La distance minimale Dmin séparant deux sources est imposée par leur interaction magnétique. Elle est de l'ordre de deux fois le diamètre de l'aimant d'une source élémentaire. En deçà, l'interaction entre aimants, déplace la zone de RCE. Dans le cas de polarités opposées entre les deux aimants, la zone se rapproche trop de la surface de la source ; dans l'autre cas, elle s'en éloigne trop.

De la surface de la source, le plasma s'étale sur une distance $Rmax_o$ d'environ 5 cm à une pression $P_o$ de $2.10^{-3}$ mbar. L'espacement maximum Dmax entre deux sources est donc limité à deux fois cette distance (environ 10cm). A pression plus faible, l'espacement maximum pourra être plus grand et, à pression plus haute, il sera plus faible. Cette distance est donc inversement proportionnelle à la pression :

$$Dmax = 2\ Rmax_o\ \frac{P_o}{P}$$

Pour produire un traitement homogène suivant la hauteur du réacteur, la position relative des différentes sources doit donc être comprise entre Dmin et Dmax.

Dans un exemple de réalisation, les pièces à traiter peuvent être disposées sur un porte substrat de capacité de rotation selon un ou plusieurs mouvements et du type de ceux utilisés dans le domaine du dépôt PVD comme la pulvérisation magnétron. La distance minimale des pièces par rapport aux sources, est définie comme étant la distance considérée au plus prêt lors du mouvement. On a pu constater qu'une distance minimale comprise entre 40 et 160 mm environ donne une qualité de traitement adéquat au niveau de l'homogénéité recherchée.

Dans cet exemple on regarde l'homogénéité d'épaisseur d'un dépôt réalisé à partir des sources RCE micro-ondes en utilisant comme précurseur gazeux un hydrocarbure. Les éprouvettes sont disposées à différentes distances minimales des sources en regard de ces dernières. On compare un traitement en statique, c'est-à-dire avec les substrats restant immobiles, et un traitement avec un mouvement planétaire. La figure illustre la décroissance de la vitesse de dépôt lorsque la distance à la rangée de sources augmente. Dans le cas du mouvement planétaire la distance sources-substrat correspond à la distance minimale du substrat aux sources pendant le mouvement. On voit clairement que le mouvement permet d'atténuer la chute de la vitesse de dépôt.

L'invention trouve une application avantageuse pour le traitement de surface à différents niveaux, tel que, d'une manière indicative nullement limitative, le nettoyage des pièces par décapage ionique, l'assistance ionique à un procédé de dépôt PVD ou encore d'activation d'espèces gazeuses pour faire des revêtements PACVD. Comme indiqué dans le préambule, ces techniques de traitement par plasma sont utilisées dans de nombreux domaines, tels que la mécanique, l'optique, de la protection corrosion ou le traitement de surface pour la production d'énergie.

Les avantages ressortent bien de la description, en particulier on souligne et on rappelle que le procédé et le dispositif de traitement au moyen de sources élémentaires de plasma par résonance cyclotronique électronique permet :

- le traitement de pièces métalliques ou non, de géométrie variable et quelconque en utilisant une configuration unique d'équipement ;
- l'obtention de traitement homogène sur des surfaces complexes et variées, sans qu'il soit pour autant nécessaire de modifier la géométrie de l'équipement en fonction de la géométrie des pièces. L'invention est définie par les revendications.

**Revendications**

1. Procédé de traitement de surface d'au moins une pièce au moyen de sources élémentaires de plasma par résonance cyclotronique électronique, consistant à soumettre la ou les pièces (1) à au moins un mouvement de révolution par rapport à au moins une rangée linéaire fixe de sources élémentaires (2), la ou lesdites rangées linéaires de sources élémentaires (2) étant disposée(s) d'une manière parallèle à l'axe ou aux axes de révolution de la ou des pièce(s), **caractérisé en ce que** la distance Dmax entre sources est déterminée par la formule :

$$Dmax = 2\ Rmax_0\ \frac{P_0}{P}$$

formule dans laquelle : $Rmax_0$ est environ de 5cm, $P_0$ de $2.10^{-3}$ mbar, P étant la pression de travail en mbar.

2. Procédé selon la revendication 1, *caractérisé* **en ce que** le mouvement de révolution est une rotation simple.

3. Procédé selon la revendication 1, *caractérisé* **en ce que** le mouvement de révolution est un mouvement planétaire, simple ou double.

4. Procédé selon l'une quelconque des revendications 1 à 3, *caractérisé* **en ce que** les sources élémentaires (2) sont constituées d'un guide d'onde coaxial et d'un embout contenant un aimant déterminé pour permettre la résonance cyclotronique électronique.

5. Procédé selon la revendication 4, *caractérisé* **en ce que** l'axe d'aimantation de l'aimant est colinéaire avec l'axe du guide d'onde pour préserver la symétrie de révolution dudit guide et pour garantir que les trajectoires des électrons se referment sur elles-mêmes.

6. Procédé selon l'une quelconque des revendications 1 à 5, *caractérisé* **en ce que** les sources élémentaires sont alimentées par un générateur unique dont la puissance est divisée en parts égales entre les sources.

7. Procédé selon l'une quelconque des revendications 1 à 5, *caractérisé* **en ce que** les sources élémentaires sont alimentées par des générateurs dont la puissance est ajustée pour avoir un plasma homogène le long de la rangée desdites sources.

8. Procédé selon l'une quelconque des revendications 1 à 7, *caractérisé* **en ce que** la distance minimale des sources, par rapport aux pièces, est la distance considérée au plus prêt lors du mouvement et est comprise entre 40 et 160 mm environ.

**Patentansprüche**

1. Verfahren zur Oberflächenbehandlung von wenigstens einem Teil durch elementare Plasmaquellen durch Elektronen-Zyklotron-Resonanz, wobei das Verfahren darin besteht, das oder die Teile (1) in mindestens eine umlaufende Bewegung bezogen auf eine starre, linienförmige Anordnung von Elementarquellen (2) zu versetzen, wobei diese linienförmigen Anordnungen von Elementarquellen (2) parallel zu der oder den Umlaufachsen des oder der Teile angeordnet sind, **dadurch gekennzeichnet dass** der Abstand Dmax zwischen den Quellen bestimmt ist durch die Formel:

$$Dmax = 2\ Rmax_0\ \frac{P_0}{P}$$

Formel, wonach: $Rmax_o$ ungefähr 5 cm und $P_o$ $2.10^{-3}$ mbar beträgt, wobei P der Arbeitsdruck in mbar ist.

**2.** Verfahren nach Anspruch 1, **dadurch gekennzeichnet, dass** es sich bei der umlaufenden Bewegung um eine einfache Drehbewegung handelt.

**3.** Verfahren nach Anspruch 1, **dadurch gekennzeichnet, dass** es sich bei der umlaufenden Bewegung um eine einfache oder doppelte Planetenbewegung handelt.

**4.** Verfahren nach einem der Ansprüche 1 bis 3, **dadurch gekennzeichnet, dass** die Elementarquellen (2) aus einem koaxialen Wellenleiter und zur Elektronen-Zyklonen-Resonanz aus einem Endstück mit einem festgelegten Magneten bestehen.

**5.** Verfahren nach Anspruch 4, **dadurch gekennzeichnet, dass** die Magnetisierungsachse des Magneten mit der Wellenleiterachse kollinear ist, um die Umlaufsymmetrie des Leiters zu erhalten und zu gewährleisten, dass sich die Elektronenbahnen schließen.

**6.** Verfahren nach einem der Ansprüche 1 bis 5, **dadurch gekennzeichnet, dass** die Elementarquellen durch einen einzigen Generator versorgt werden, dessen Leistung zu gleichen Teilen unter den Quellen aufgeteilt ist.

**7.** Verfahren nach einem der Ansprüche 1 bis 5, **dadurch gekennzeichnet, dass** die Elementarquellen durch Generatoren versorgt werden, deren Leistung angepasst wird, um entlang der gesamten Quellenanordnung über homogenes Plasma zu verfügen.

**8.** Verfahren nach einem der Ansprüche 1 bis 7, **dadurch gekennzeichnet, dass** der Mindestabstand der Quellen zu den Teilen dem genau betrachteten Abstand während der Bewegung entspricht und ungefähr zwischen 40 und 160 mm liegt.

**Claims**

**1.** Method of treating a surface of at least one part by means of elementary electron cyclotron resonance plasma sources, the method consisting in subjecting the part(s) (1) to at least one movement of revolution relative to at least one fixed linear row of elementary sources (2), the or said row(s) of elementary sources (2) being disposed parallel to the axis(axes) of revolution of the part(s), **characterized in that** the maximum distance Dmax between sources is determined by the following formula:

$$Dmax = 2\ Rmax_0\ \frac{P_0}{P}$$

formula wherein : $Rmax_0$ is about 5 cm, $P_0$ is about $2.10^{-3}$ mbar, and P is the working pressure in mbar.

**2.** Method according to claim 1, **characterized in that** the movement of revolution is a single rotation.

**3.** Method according to claim 1, **characterized in that** the movement of revolution is a single or double planetary movement.

**4.** Method according to any one of claims 1 to 3, **characterized in that** each of the elementary sources (2) is constituted by a coaxial waveguide and by an end-piece containing a magnet determined for making the electron cyclotron resonance possible.

**5.** Method according to claim 4, **characterized in that** the magnetization axis of the magnet is co-linear with the axis of the waveguide so as to preserve the symmetry of revolution of said waveguide and so as to guarantee that the paths of the electrons loop back on themselves.

**6.** Method according to any one of claims 1 to 5, **characterized in that** the elementary sources are fed by a single generator having its power divided into equal shares between the sources.

7. Method according to any one of claims 1 to 5, **characterized in that** the elementary sources are fed by generators having their power adjusted to have plasma that is uniform along the row of said sources.

8. Method according to any one of claims 1 to 7, **characterized in that** the minimum distance between the sources, relative to and the parts is the closest distance during the movement and lies approximately in the range 40 mm to 160 mm.

FIG.1

FIG.2

FIG.3

FIG.4

FIG.5

FIG.6

FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2658025
- FR 2838020
- FR 2797372
- WO 2007023350 A
- FR 2826506
- US 5378284 A
- FR 2798552